# EUROPÄISCHE PATENTSCHRIFT

(11) **EP 2 878 183 B1**
(45) Veröffentlichungstag und Bekanntmachung des Hinweises auf die Patenterteilung: **28.08.2019**
(21) Anmeldenummer: 13742433.9
(22) Anmeldetag: 25.07.2013
(51) Int. Cl.: H05K 7/14

(54) **FELDBUSBAUKASTENSYSTEM, TRÄGERMODUL UND FELDBUSMODUL**
MODULAR FIELDBUS SYSTEM, CARRIER MODULE AND FIELDBUS MODULE
SYSTÈME DE BUS DE TERRAIN MODULAIRE, MODULE SUPPORT ET MODULE BUS DE TERRAIN

(30) Priorität: 27.07.2012 DE 102012213281
(43) Veröffentlichungstag der Anmeldung: 03.06.2015
(73) Patentinhaber: Phoenix Contact GmbH & Co KG, 32825 Blomberg (DE)
(72) Erfinder: BURY, Joachim, 32052 Herford (DE); SALOMON, Thomas, 33415 Verl (DE)
(74) Vertreter: Patentship Patentanwaltsgesellschaft mbH
(86) Internationale Anmeldenummer: PCT/EP2013/065748
(87) Internationale Veröffentlichungsnummer: WO 2014/016384

(56) Entgegenhaltungen:
- EP-A1- 0 592 712
- WO-A1-02/23676
- DE-C1- 19 514 767
- DE-U1- 20 211 002

## Beschreibung

Die vorliegende Erfindung betrifft ein Feldbusbaukastensystem mit einem Trägermodul und einem Feldbusmodul.

Die Energieverteilung in Feldbussystemen in Schaltschränken erfolgt oftmals über Stromschienensysteme mit Tragfunktion oder fliegende Verbindungen ohne Tragfunktion, wie beispielsweise Verteilerkämme oder Drahtverbindungen. Eine Signalverteilung erfolgt beispielsweise über Steuerleitungen und Geräteanschlussklemmen oder Busleitungen mit Steckverbindern oder Geräteanschlussklemmen. Die Funktionsverteilung erfolgt über einzelne Feldbusmodule, die in Einzelgehäusen nebeneinander gestellt und verdrahtet werden.

Außerhalb eines Schaltschranks erfolgt die Energieverteilung durch Leitungen und Stecksysteme ohne Tragfunktion getrennt nach Nieder- und Kleinspannung. Die Signalverteilung erfolgt über Busleitungen mit Steckverbindern oder Geräteanschlussklemmen. Die Funktionsverteilung erfolgt applikationsspezifisch in Gehäusen, die miteinander kombiniert werden.

Die Druckschrift DE 20 211 002 U1 betrifft ein Feldbusmodul für ein elektrisches Gerät mit einer Grundmoduleinheit, die an eine Unterlage wie eine Maschine angeschraubt werden kann. Die Grundmoduleinheit kann kettenartig mit anderen Grundmoduleinheiten aneinander gereiht werden. Auf jede der Grundmoduleinheiten ist eine entsprechende Anschlusseinheit aufsetzbar. Bei diesem System wird für jede Anschlusseinheit mit einer jeweiligen Breite eine passende Grundmoduleinheit benötigt. Dadurch erhöht sich die Anzahl der Systemkomponenten.

Die Druckschrift DE 195 14 767 C1, betrifft eine gekapselte Ein-/Ausgabebaugruppe der Steuerungstechnik, mit einem an der Vorderseite der Kapselung angeordneten U-förmigen Aufnahmekanal zur Aufnahme eines Frontsteckers, an den über Anschlusselemente Prozessleitungen anschließbar sind, wobei sich eine in der Kapselung angeordnete Leiterplatte seitlich bis in den Bereich des Aufnahmekanals erstreckt.

Es ist daher die Aufgabe der vorliegenden Erfindung ein Feldbusbaukastensystem bereitzustellen, das mit einer geringen Anzahl an unterschiedlichen Einzelkomponenten auf einfache technische Weise zusammengesetzt werden kann.

Diese Aufgabe wird durch Gegenstände mit den Merkmalen nach den unabhängigen Ansprüchen gelöst. Vorteilhafte Ausführungsformen sind Gegenstand der abhängigen Ansprüche, der Beschreibung und der Zeichnungen.

Gemäß einem ersten Aspekt wird die oben genannte Aufgabe durch ein Trägermodul für Feldbusmodule gelöst, das auf ein Tragprofil aufrastbar und auf dem Tragprofil verschiebbar ist, mit einem ersten Steckverbinder zum elektrischen und mechanischen Verbinden eines ersten, beispielsweise linksseitigen Feldbusmoduls mit dem Trägermodul und einem zweiten Steckverbinder zum elektrischen und mechanischen Verbinden eines zweiten, beispielsweise rechtseitigen Feldbusmoduls mit dem Trägermodul. Durch das Trägermodul wird der Vorteil erreicht, dass sich eine verlängerbare Kette an Feldbusmodulen errichten lässt, deren Stabilität durch die Profilschiene gewährleistet wird. Die Kette bildet einen selbst aufbauenden Bus, dessen Länge skaliert werden kann und den Applikationsanforderungen angepasst werden kann. Feldbusmodule unterschiedlicher Breite lassen sich über das gleiche Trägermodul aneinander reihen. Die Aufbaurichtung des Systems kann in beiden Richtungen entlang der Schiene erfolgen.

Gemäß der Erfindung umfasst der erste Steckverbinder einen ersten Niederspannungssteckverbinder, einen ersten Kleinspannungssteckverbinder und einen ersten Datensteckverbinder und der zweite Steckverbinder einen zweiten Niederspannungssteckverbinder, einen zweiten Kleinspannungssteckverbinder und einen zweiten Datensteckverbinder. Dadurch wird beispielsweise der technische Vorteil erreicht, dass ein selbst aufbauender Bus für die drei Funktionen - Hauptenergie, Hilfsenergie und Daten - gebildet werden kann. Weiter kann die übliche manuelle Verdrahtung von Steuersignalen und Datenbus, Hilfsenergie und Hauptenergie entfallen. Überschießende Längen von Stromschienen und zur Verdrahtung verwendete Leitungen können eingespart werden.

Gemäß der Erfindung sind der erste Niederspannungssteckverbinder, der erste Kleinspannungssteckverbinder und der erste Datensteckverbinder in einer ersten Reihe an einer ersten Seite des Trägermoduls und der zweite Niederspannungssteckverbinder, der zweite Kleinspannungssteckverbinder und der zweite Datensteckverbinder in einer zweiten Reihe an einer zweiten Seite des Trägermoduls angeordnet. Dadurch wird beispielsweise der technische Vorteil erreicht, dass sich eine elektrische und mechanische Verbindung zwischen dem Trägermodul und den Feldbusmodulen auf einfache Weise herstellen lässt. Daneben kann bei einer derartigen Anordnung der Steckverbinder das Trägermodul schmal gestaltet werden.

In einer weiteren vorteilhaften Ausführungsform des Trägermoduls umfasst das Trägermodul eine Arretierungsöffnung zum Einsetzen eines Arretierungsschaftes, um ein Feldbusmodul auf dem Trägermodul zu arretieren. Dadurch wird beispielsweise der technische Vorteil erreicht, dass sich das Feldbusmodul zuverlässig auf dem Trägermodul befestigen lässt.

In einer weiteren vorteilhaften Ausführungsform des Trägermoduls umfasst das Trägermodul eine erste und eine zweite Arretierungsöffnung für ein linksseitiges Feldbusmoduls und eine erste und eine zweite Arretierungsöffnung für ein rechtsseitiges Feldbusmodul. Dadurch wird beispielsweise der technische Vorteil erreicht, dass sich sowohl ein rechtsseitiges als auch ein linksseitiges Feldbusmodul zuverlässig auf dem Trägermodul befestigen lassen.

In einer weiteren vorteilhaften Ausführungsform des Trägermoduls weist das Trägermodul eine im Querschnitt rechteckige Grundfläche auf und die erste Arretierungsöffnung für das linksseitige Feldbusmodul ist in einer ersten Ecke, die zweite Arretierungsöffnung für das linksseitige Feldbusmodul ist in einer zweiten Ecke, die erste Arretierungsöffnung für das rechtsseitige Feldbusmodul ist in einer dritten Ecke und die zweite Arretierungsöffnung für das rechtsseitige Feldbusmodul ist in einer vierten Ecke angeordnet. Dadurch wird beispielsweise der technische Vorteil erreicht, dass eine besonders stabile Arretierung beider Feldbusmodule auf dem Trägermodul erreicht wird.

Gemäß einem zweiten Aspekt wird die oben genannte Aufgabe durch ein Feldbusmodul zum Aufstecken auf ein linksseitiges Trägermodul und ein rechtseitiges Trägermodul gelöst, die auf einem Tragprofil angeordnet sind, mit einem ersten Steckverbinder zum elektrischen und mechanischen Verbinden des Feldbusmoduls mit dem rechtseitigen Trägermodul und einem zweiten Steckverbinder zum elektrischen und mechanischen Verbinden des Feldbusmoduls mit dem linksseitigen Trägermodul. Durch die Ausgestaltung des Feldbusmoduls wird der Vorteil erreicht, dass sich bei Verwendung der auf der Profilschiene verschiebbaren Trägermodule eine beliebig verlängerbare Kette an Feldbusmodulen errichten lässt, deren Stabilität durch die Profilschiene gewährleistet wird. Feldbusmodule unterschiedlicher Breite lassen sich durch das gleiche Trägermodul aneinander reihen. Die Aufbaurichtung des Systems kann in beiden Richtungen entlang der Schiene erfolgen.

Gemäß der Erfindung umfasst der erste Steckverbinder einen ersten Niederspannungssteckverbinder, einen ersten Kleinspannungssteckverbinder und einen ersten Datensteckverbinder und der zweite Steckverbinder einen zweiten Niederspannungssteckverbinder, einen zweiten Kleinspannungssteckverbinder und einen zweiten Datensteckverbinder. Dadurch wird beispielsweise ebenfalls der technische Vorteil erreicht, dass ein sich selbst aufbauender Bus für die drei Funktionen - Hauptenergie, Hilfsenergie und Daten - gebildet werden kann.

Gemäß der Erfindung sind der Niederspannungssteckverbinder, der erste Kleinspannungssteckverbinder und der erste Datensteckverbinder in einer ersten Reihe an einer ersten Seite des Feldbusmoduls und der zweite Niederspannungssteckverbinder, der zweite Kleinspannungssteckverbinder und der zweite Datensteckverbinder in einer zweiten Reihe an einer zweiten Seite des Feldbusmoduls angeordnet. Dadurch wird beispielsweise der technische Vorteil erreicht, dass sich eine elektrische und mechanische Verbindung zwischen dem Trägermodul und den Feldbusmodulen auf einfache Weise herstellen lässt.

In einer weiteren vorteilhaften Ausführungsform des Feldbusmoduls umfasst das Feldbusmodul einen Arretierungsschaft zum Einsetzen in eine Arretierungsöffnung in dem Trägermodul, um das Feldbusmodul auf dem Trägermodul zu arretieren. Der Arretierungsschaft kann entlang seiner Längsachse verschiebbar sein. Zusätzlich kann der Arretierungsschaft mit einer Federkraft beaufschlagt sein. Dadurch wird beispielsweise ebenfalls der technische Vorteil erreicht, dass sich das Feldbusmodul zuverlässig auf dem Trägermodul befestigen lässt.

In einer weiteren vorteilhaften Ausführungsform des Feldbusmoduls umfasst das Feldbusmodul einen ersten Arretierungsschaft und einen zweiten Arretierungsschaft für ein linksseitiges Trägermodul und einen ersten Arretierungsschaft und einen zweiten Arretierungsschaft für ein rechtsseitiges Trägermodul. Dadurch wird beispielsweise ebenfalls der technische Vorteil erreicht, dass sich sowohl ein rechtsseitiges als auch ein linksseitiges Feldbusmodul zuverlässig auf dem Trägermodul befestigen lassen.

In einer weiteren vorteilhaften Ausführungsform des Feldbusmoduls weist das Feldbusmodul eine im Querschnitt rechteckige Grundfläche auf und der erste Arretierungsschaft für das linksseitige Trägermodul ist in einer ersten Ecke, der zweite Arretierungsschaft für das linksseitige Trägermodul ist in einer zweiten Ecke, der erste Arretierungsschaft für das rechtsseitige Trägermodul ist in einer dritten Ecke und der zweite Arretierungsschaft für das rechtsseitige Trägermodul ist in einer vierten Ecke angeordnet. Dadurch wird beispielsweise der technische Vorteil erreicht, dass eine besonders stabile Arretierung beider Feldbusmodule auf dem Trägermodul erreicht wird.
In einer weiteren vorteilhaften Ausführungsform des Feldbusmoduls ist der Arretierungsschaft durch einen Arretierungshebel zwischen einer Freigabeposition zum Freigeben des Feldbusmoduls und einer Verriegelungsposition zum Verriegeln des Feldbusmoduls drehbar. Dadurch wird beispielsweise der technische Vorteil erreicht, dass das Feldbusmodul in einfacher Weise durch Drehen eines Arretierungshebels befestigt werden kann.

Gemäß einem dritten Aspekt wird die oben genannte Aufgabe durch ein Feldbusbaukastensystem mit einem Trägermodul nach dem ersten Aspekt und einem Feldbusmodul nach dem zweiten Aspekt gelöst. Dadurch wird der technische Vorteil erreicht, dass ein flexibles System zum Verlängern eines Bus bereitgestellt wird und Komponenten weitest möglich aus Wiederholteilen gebildet sind.

Gemäß einem vierten Aspekt wird die oben genannte Aufgabe durch ein Trägermodul nach dem ersten Aspekt und einem ersten und einem zweiten Feldbusmodul nach dem zweiten Aspekt gelöst, bei dem durch das Trägermodul ein Abstand zwischen dem ersten Feldbusmodul und dem zweiten Feldbusmodul herstellbar ist, um eine Luftkonvektion zwischen dem ersten Feldbusmodul und dem zweiten Feldbusmodul zu ermöglichen. Dadurch wird beispielsweise der technische Vorteil erreicht, dass die Feldbusmodule auch im gegenseitigen Zwischenraum durch vorbeiströmende Luft gekühlt werden.

Weitere Ausführungsbeispiele werden Bezug nehmend auf die beiliegenden Zeichnungen erläutert. Es zeigen:
- Fig. 1: eine Ansicht eines Trägermoduls;
- Fig. 2: eine Querschnittsansicht durch das Trägermodul;
- Fig. 3: eine Rückansicht einer Grundplatte des Trägermoduls;
- Fig. 4: eine Ansicht eine Feldbusmoduls;
- Fig. 5: eine Querschnittsansicht durch mehrere Trägermodule mit unterschiedlichen aufgesetzten Feldbusmodulen;
- Fig. 6: eine perspektivische Ansicht des Feldbusbaukastensystem;
- Fig. 7: eine Querschnittsansicht durch einen Arretierungshebel und einen Arretierungsschaft in einem Feldbusmodul;
- Fig. 8: eine Querschnittsansicht durch den Arretierungshebel in dem Feldbusmodul;
- Fig. 9: eine Querschnittsansicht durch den Arretierungsschaft in dem Feldbusmodul;
- Fig. 10: eine Ansicht des Arretierungshebels ohne Feldbusmodul; und
- Fig. 11: eine Querschnittsansicht durch den Arretierungshebel ohne Feldbusmodul.

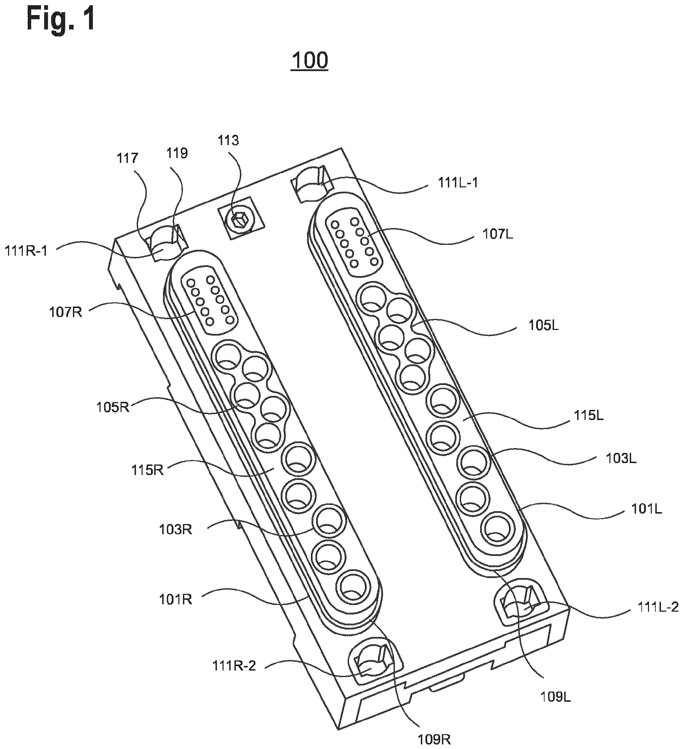

Fig. 1 zeigt eine Ansicht eines Trägermoduls 100 für Feldbusmodule. Das Trägermodul 100 dient als Trag- und Verbindungselement und ist auf ein Tragprofil, wie beispielsweise eine Metallschiene, aufschwenkbar, mit einem Rastschieber verrastbar und anschließend noch verschiebbar. Nach einer Endpositionierung ist das Trägermodul 100 seitlich mit einer Schraube 113 arretierbar. Das Trägermodul 100 bildet zusammen mit den einzelnen, auf das Trägermodul aufsetzbaren Feldbusmodulen einen selbst aufbauenden Stationsbus mit durchverbundenen Lebensadern.

Das Trägermodul 100 umfasst einen ersten Steckverbinder 101L zum elektrischen und mechanischen Verbinden eines linksseitigen Feldbusmoduls mit dem Trägermodul 100 und einen zweiten Steckverbinder 101R zum elektrischen und mechanischen Verbinden eines rechtseitigen Feldbusmoduls mit dem Trägermodul 100. Der erste und der zweite Steckverbinder 101L und 101R umfassen jeweils einen Niederspannungssteckverbinder 103L und 103R für eine Niederspannung (5-polig), einen Kleinspannungssteckverbinder 105L und 105R für eine Kleinspannung (5-polig) und einen Datensteckverbinder 107L und 107R für Daten (10-polig). Dadurch lässt sich ein Bus mit den Funktionen - Hauptenergie, Hilfsenergie und Daten - aufbauen.

Der erste Niederspannungssteckverbinder 103L, der erste Kleinspannungssteckverbinder 105L und der erste Datensteckverbinder 107L sind in einer senkrechten Reihe 109L an einer ersten Seite des Trägermoduls 100 angeordnet. Der zweite Niederspannungssteckverbinder 103R, der zweite Kleinspannungssteckverbinder 105R und der zweite Datensteckverbinder 107R sind in einer zweiten Reihe 109R an einer zweiten Seite des Trägermoduls 100 angeordnet. Die erste Reihe 109L und die zweite Reihe 109R sind parallel zueinander angeordnet.

Der erste und der zweite Steckverbinder 101L und 101R umfassen somit jeweils drei Kontaktsätze in einem linearen Kontaktträger. Der erste Kontaktsatz umfasst beispielsweise fünf Kontakte mit einem Querschnitt von 10 mm² für eine Wechselspannung von 690 V, der zweite Kontaktsatz umfasst beispielsweise fünf Kontakte mit einem Querschnitt von 6 mm² für eine Gleichspannung von 100 V und der dritte Kontaktsatz umfasst beispielsweise zehn Kontakte mit einem Querschnitt von 0,14 mm² für eine Spannung von 40 V für Daten. Dadurch lässt sich eine Energieverteilung 2 x 5polig für 400 V / 24 V bis 10 mm² aufbauen.

In den jeweiligen Kontaktsätzen sind Elastomerkörper 115L und 115R eingesetzt, die als Berührschutz dienen, den Kontaktsatz abdichten und ein federndes Gegenlager für die Arretierung bilden. Jeder Elastomerkörper dichtet sowohl radial als auch axial ab und ist von einem Benutzer austauschbar.

Zwischen je zwei Trägermodule 100 lassen sich Feldbusmodule aufstecken, die mit einer mechanischen Führung und einem entsprechenden links- und rechtsseitigen Steckverbinder auf ein linkes und ein rechtes Trägermodul 100 aufrasten.

Die mechanische Verbindung zwischen den Trägermodulen 100 und den Feldbusmodulen erfolgt über jeweils zwei Arretierungsöffnungen 111L-1, 111L-2, 111R-1 und 111R-2 oberhalb und unterhalb des ersten und des zweiten Steckverbinders 101L und 101R. In die Arretierungsöffnungen 111L-1, 111L-2, 111R-1 und 111R-2 lassen sich ausgehend von dem jeweiligen Feldbusmodul entsprechende Arretierungsschäfte mit Querriegeln einsetzen, die jeweils bei einer Drehung in den Arretierungsöffnungen 111L-1, 111L-2, 111R-1 und 111R-2 arretieren. Die Arretierungsöffnungen 111L-1, 111L-2, 111 R-1 und 111 R-2 weisen eine abgeschrägte Innenseite auf, um ein Einsetzen des Arretierungsschaftes zu unterstützen. Der Querriegel des Arretierungsschafts wird durch zwei seitliche Aussparungen 117 und 119 im Inneren der Arretierungsöffnungen 111L-1, 111L-2, 111R-1 und 111R-2 geführt.

Dadurch wird eine Befestigung und Verriegelung des Feldbusmoduls auf dem Trägerelement 100 erreicht. Die vier Arretierungsöffnungen 111L-1, 111L-2, 111R-1 und 111R-2 sind in den einzelnen Ecken des Trägermoduls 100 angeordnet.

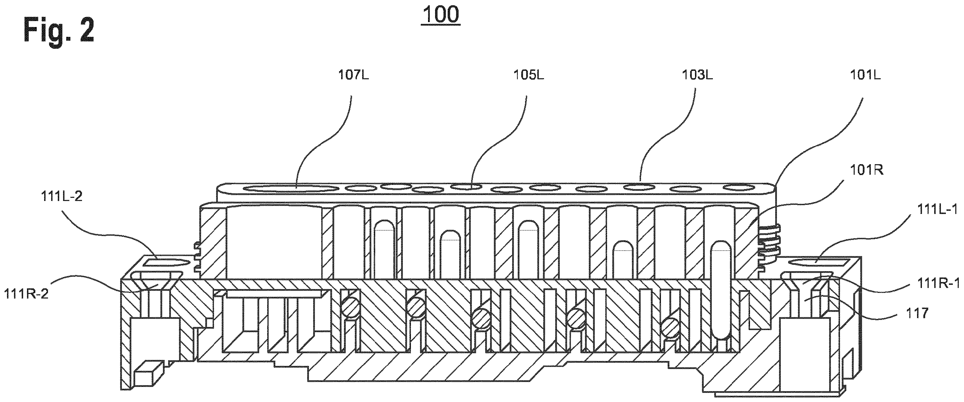

Fig. 2 zeigt eine Querschnittsansicht durch das Trägermodul 100. Nach einer Drehung um 90° hintergreift der Querriegel das Trägermodul 100, so dass die mechanische Verbindung verriegelt ist.

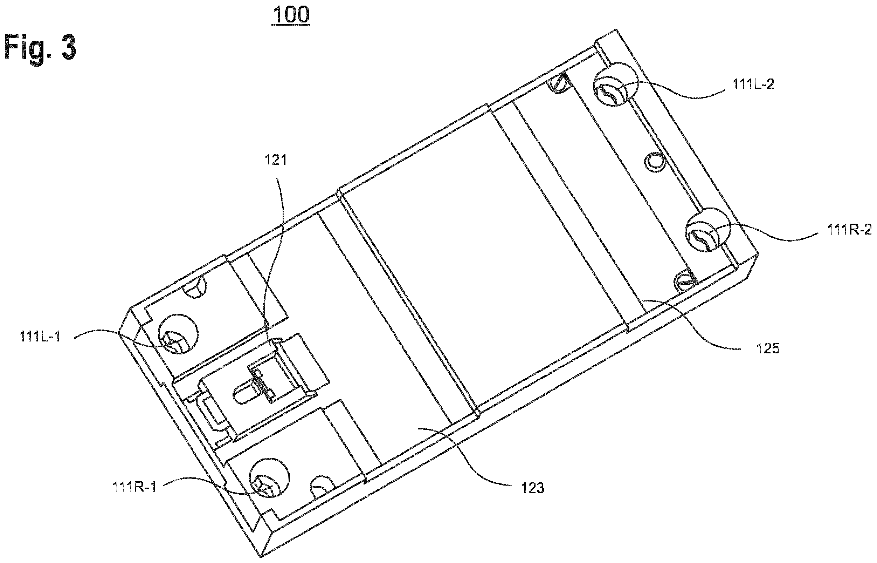

Fig. 3 zeigt eine Rückansicht einer Grundplatte des Trägermoduls 100. Die Rückseite des Trägermoduls 100 umfasst zwei Aussparungen 123 und 125, in denen ein oberes und ein unteres Tragprofil beim Aufsetzen des Trägermoduls 100 verlaufen. Das Trägermodul 100 umfasst eine Rasteinrichtung 121 zum Einrasten des Trägermoduls auf dem Tragprofil. Nach dem Einrasten auf dem Tragprofil ist das Trägermodul 100 weiter seitlich entlang dem Tragprofil verschiebbar.

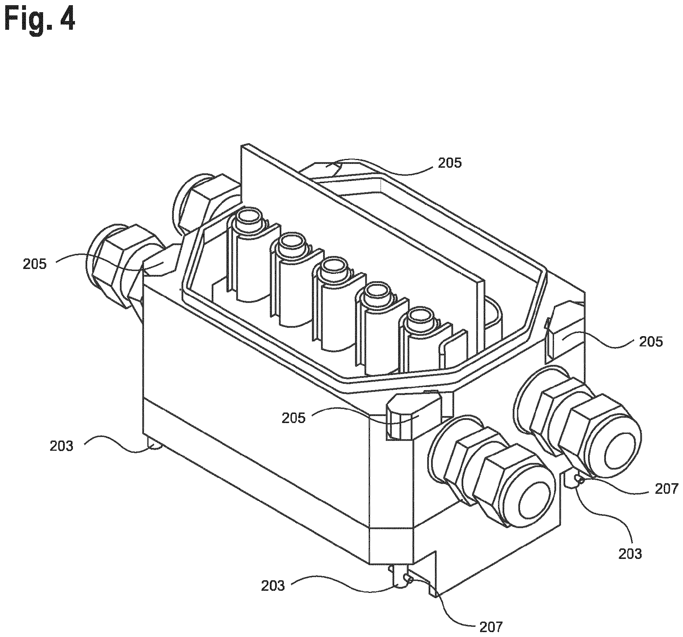

Fig. 4 zeigt eine Ansicht eines Feldbusmoduls 200. Das Feldbusmodul 200 wird durch Einhängen, Schwenken oder Stecken in ein linkes Trägermodul 100 in dem System angereiht und zusammengefügt. Ein weiteres rechtes Trägermodul 100 wird auf dem Tragprofil in eine passende Position geschoben werden, so dass das Feldbusmodul 200 auf das rechte Trägermodul 100 aufgesetzt werden kann. Anschließend wird das Feldbusmodul 200 mithilfe der vier Arretierungshebel 205 an dem linken und dem rechten Trägermodul 100 befestigt.

Zu diesem Zweck werden die Arretierungshebel 205 des Feldbusmoduls 200 vor dem Aufstecken um 90° gedreht, damit die Querriegel 207 der Arretierungsschäfte 203 zum Fügen passend gestellt sind. Nach dem Zusammenstecken des Feldbusmoduls 200 mit dem Trägermodul 100 werden die Arretierungshebel 203 wieder um 90° zurückgedreht. Dadurch sind die Kontaktsätze des Trägermoduls 100 und des Feldbusmoduls 200 kraftschlüssig und dicht verbunden.

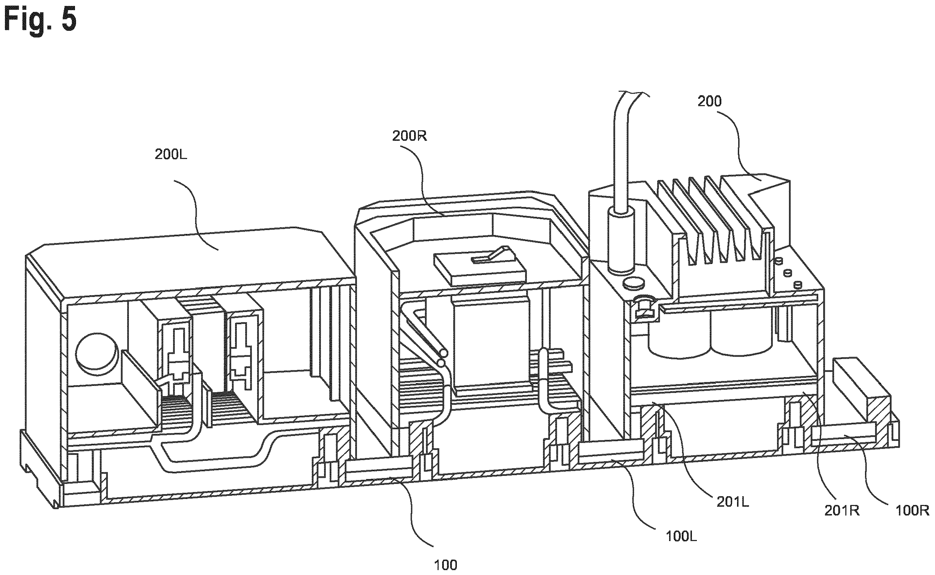

Fig. 5 zeigt eine Querschnittsansicht durch mehrere Trägermodule 100L und 100R mit unterschiedlichen aufgesetzten Feldbusmodulen 200L und 200R und einen internen Verlauf der Lebensadern. Das Feldbusmodul 200R wird mit einem ersten Steckverbinder 201L auf ein linkseitiges Trägermodul 100L und mit dem einem zweiten Steckverbinder 201R auf ein rechtseitiges Trägermodul 100R aufgesetzt.

Die Trägermodule 100 und die Feldbusmodule 200 bilden so eine Kette, deren Stabilität durch das in Fig. 5 nicht gezeigte Tragprofil gewährleistet wird und die einen selbst aufbauenden Bus bildet. Die Länge des Bus kann durch den modularen Aufbau skaliert und den Applikationsanforderungen angepasst werden. Durch die symmetrische Anordnung des ersten und des zweiten Steckverbinders 101L und 101R des Tragmoduls 100 kann die Aufbaurichtung des Systems nach links und rechts erfolgen.

Mit dem Fügen der mechanischen Verbindung zwischen dem Trägermodul 100 und dem Feldbusmodul 200 erfolgen alle internen elektrischen Verbindungen. Für ein Lösen von Rastschiebern und Fixierungsschrauben kann ein Systemwerkzeug erforderlich sein, beispielsweise ein 6mm-Schlitzschraubendreher.

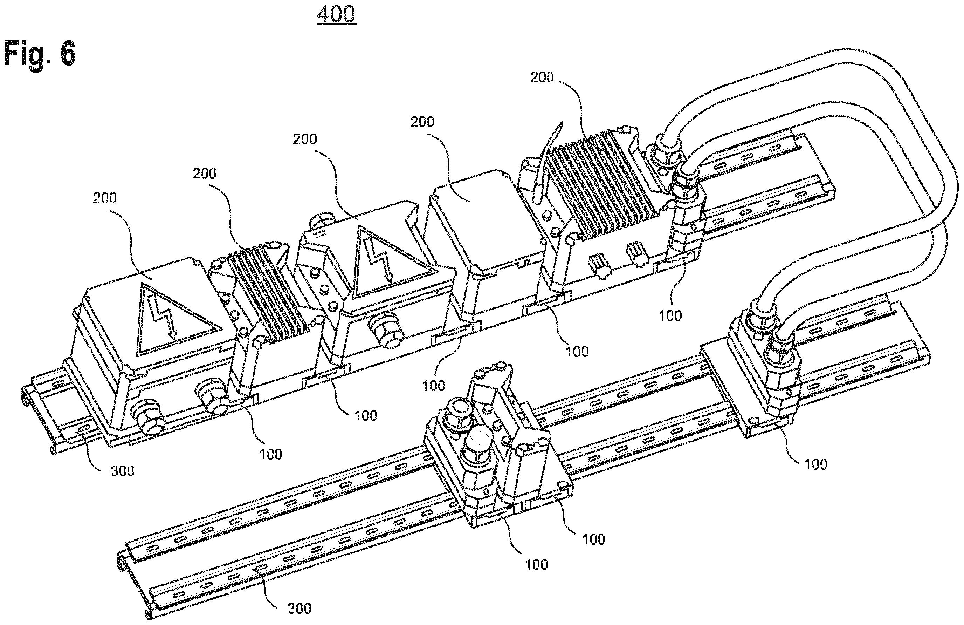

Fig. 6 zeigt eine perspektivische Ansicht des Feldbusbaukastensystems 400. Das Feldbusbaukastensystem 400 umfasst die Feldbusmodule 200 und die Trägermodule 100, die auf dem Tragprofil 300 aufgerastet sind. Das Tragprofil 300 ist durch zwei Tragschienen, beispielsweise Profilschienen aus starren Metallträgern oder einem gerollten Stahlprofil gebildet. Die obere Kante des Tragprofils 300 trägt die Last der Trägermodule 100 und der Feldbusmodule 200.

Nach dem Aufrasten sind die Trägermodule 100 verschiebbar. Sobald sich die Trägermodule 100 an der vorgesehenen Position auf dem Tragprofil 300 befinden, sind diese endarretierbar, beispielsweise durch die Fixierungsschraube 113.

Aus Gründen der Kühlung kann nach erfolgter Montage ein Abstand von beispielsweise 20 mm zwischen den Feldbusmodulen 200 vorgesehen sein, um eine Konvektion zwischen gegenüberliegenden Seitenwänden zu ermöglichen. Über die Feldbusmodule 200 werden die Feldstationen zu einem Netzwerkverbund zusammengefügt.

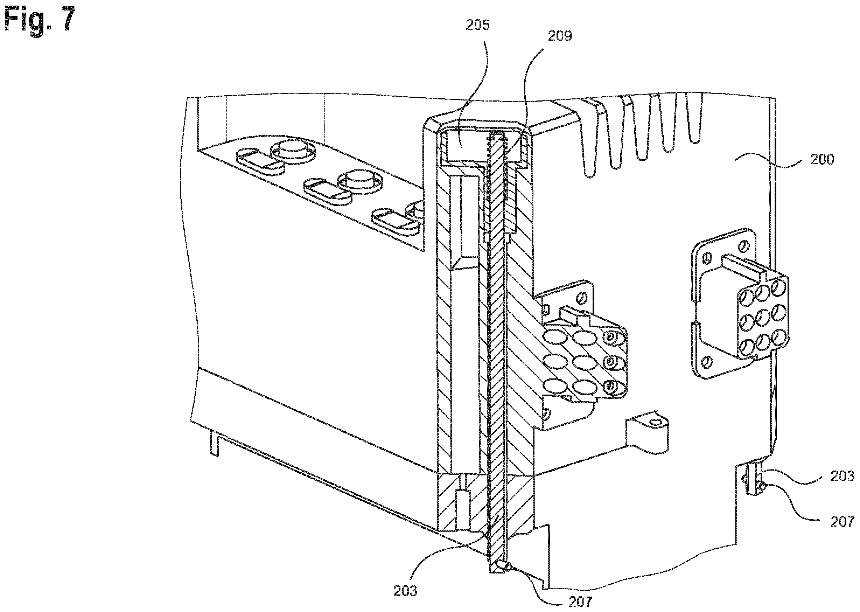

Fig. 7 zeigt eine Querschnittsansicht durch einen Arretierungshebel 205 und einen Arretierungsschaft 203 in einem Feldbusmodul 200. Der Arretierungshebel 205 ist in einer Ecke eines Gehäuses des Feldbusmoduls 200 angebracht und ist von der Vorderseite des Feldbusmoduls 200 her zugänglich und von einem Benutzer betätigbar. Der Arretierungsschaft 203 erstreckt sich im Inneren des Gehäuses und verläuft von dem Arretierungshebel 205 bis zur Rückseite des Feldbusmoduls 200. An der Rückseite des Feldbusmoduls 200 ragt der Arretierungsschaft 203 heraus, so dass dieser in die vorgesehene Arretierungsöffnung 111 eingeführt werden kann. Eine Drehung des Arretierungshebels 205 wird auf den drehbaren Arretierungsschaft 203 übertragen. Nach dem Einsetzen des Arretierungsschafts 203 in die Arretierungsöffnung 11 1 des Trägermoduls 100 kann das Feldbusmodul 200 auf dem Trägermodul 100 durch die Drehung des Arretierungsschaftes 203 verriegelt werden. Dabei hintergreift der Querriegel 207 eine Frontplatte des Trägermoduls 100.

Der Arretierungsschaft 203 ist zusätzlich entlang seiner Längsachse verschiebbar und durch die Feder 209 mit einer Kraft beaufschlagt. Durch die Federkraft wird das Feldbusmodul 200 über den Arretierungshebel 205 auf das Trägermodul 100 gedrückt. Durch die verschiebbare Aufhängung des Arretierungsschaftes 203 gegenüber dem Arretierungshebel 205 kann ein Verklemmen oder eine Blockierung des Arretierungsschaftes 203 beim Einsetzen und Drehen verhindert werden.

Das Gehäuse umfasst vier Arretierungshebel 205, die in den Ecken des Gehäuses angeordnet sind und jeweils zur Verriegelung des Feldbusmoduls 200 auf einem rechtsseitigen oder linksseitigen Trägermodul 100 dienen. Die Arretierungshebel 205 können in entsprechende Aussparungen im Gehäuse eingesenkt werden und mit diesem eine glatte, formschlüssige Kontur bilden. Die Arretierungshebel 205 werden somit in dem Gehäuse des Feldbusmoduls 200 aufgenommen und setzen die Gehäusekontur mit abgeschrägten Kanten und die Fasen nahtlos fort. Bei fehlender Verriegelung des Feldbusmoduls 200 stehen die Arretierungshebel 205 hingegen quer zum Gehäuse und signalisieren einen unvollständigen Montagevorgang.

Das Finden des Feldbusmoduls 200 beim Absenken auf die Trägermodule 100L und 100R wird durch die Steckverbinder 101L, 101R, 201L und 201R mechanisch unterstützt. Die Steckkräfte sind durch drei gestaffelte Ebenen (Voreilung) der Kontaktsätze gedrittelt. Die Auszugkräfte zum Entfernen des Feldbusmoduls 200 können durch ein einfaches Werkzeug unterstützt werden.

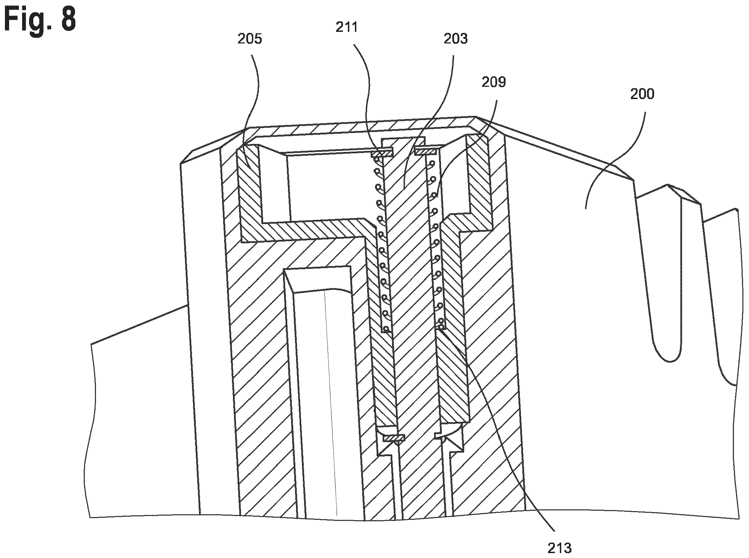

Fig. 8 zeigt eine Querschnittsansicht durch den Arretierungshebel 205 in dem Feldbusmodul 200. Der Arretierungsschaft 203 ist im Inneren des Arretierungshebels 205 verschiebbar gelagert und durch die Feder 209 mit einer Kraft beaufschlagt, die den Arretierungsschaft 203 in das Gehäuse des Feldbusmoduls 200 hineinzieht. Die Feder 209 befindet sich in einem Hohlraum im Inneren des Arretierungshebels 205 und liegt an der einen Seite an einer Kante 213 im Inneren des Arretierungshebels 205 und an der andern Seite an einer um den Arretierungsschaft 203 umlaufenden Scheibe 211 an.

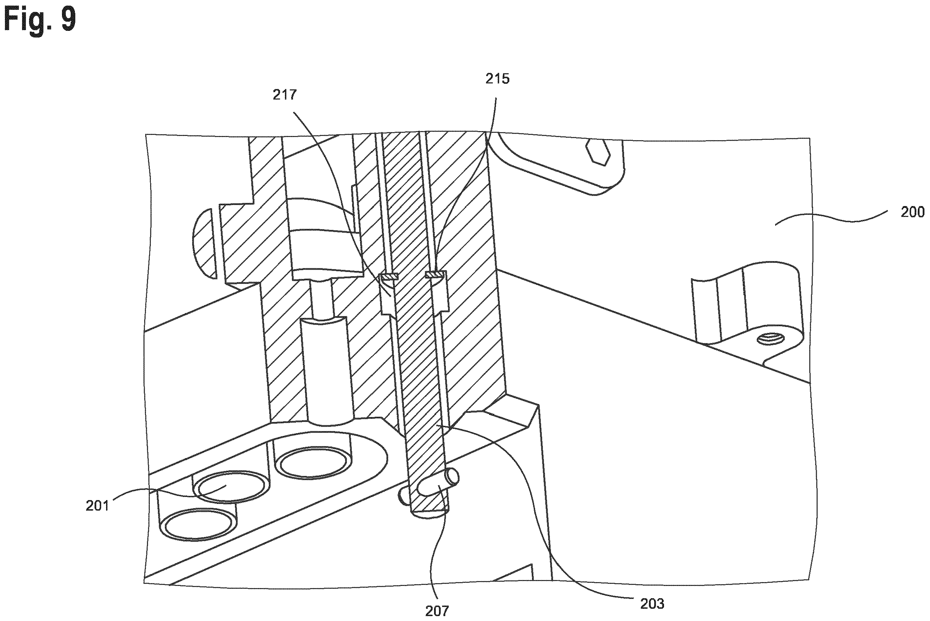

Fig. 9 zeigt eine Querschnittsansicht durch den Arretierungsschaft 203 in dem Feldbusmodul 200 an seinem unteren Ende. Der Arretierungsschaft 203 ragt an der Rückseite des Feldbusmoduls 200 heraus und ist seitlich zu dem Steckverbinder 201 des Feldbusmoduls 200 angeordnet. Zum Begrenzen einer Verschiebung des Arretierungsschafts 203 entlang seiner Längsachse umfasst der Arretierungsschaft 203 eine umlaufende Ringplatte 215. Die Ringplatte 215 ist in einem Hohlraum 217 im Inneren des Gehäuses angeordnet und begrenzt die Bewegung des Arretierungsschaftes 203, indem diese an das obere oder untere Ende des Hohlraums 217 anschlägt.

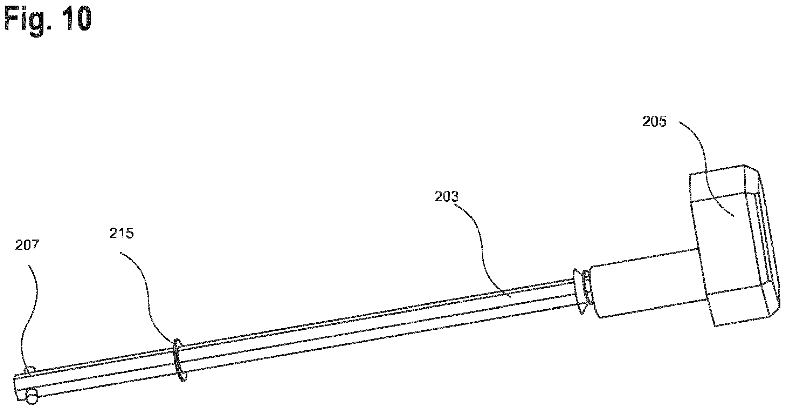

Fig. 10 zeigt eine Ansicht des Arretierungshebels 205 ohne Feldbusmodul 200. Der Arretierungsschaft 203 ist durch ein Sechskantprofil gebildet. Der Querriegel 207 ragt am unteren Ende seitlich aus dem Arretierungsschaft 203 hervor.

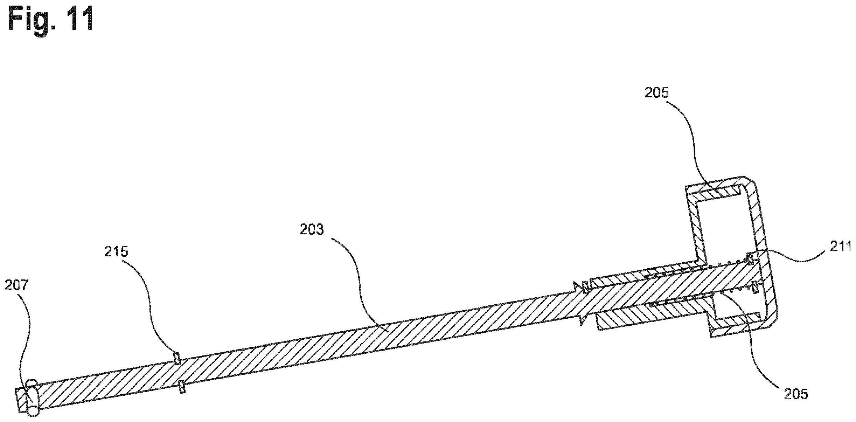

Fig. 11 zeigt die der Fig. 10 entsprechende Querschnittsansicht durch den Arretierungshebel 205 ohne Feldbusmodul 200. Im Inneren des Arretierungshebels 205 ist die Feder 209 angeordnet.

Die erfindungsgemäße Gestaltung der Feldbusmodule erlaubt einen beidseitigen linearen Geräteverbund beliebiger Länge. Der Aufbau des Feldbussystems erfolgt intuitiv, so dass die Qualifikation beim Zusammensetzen auf einen Aufbau der Mechanik reduziert werden kann. Die Arbeitsabläufe für eine Inbetriebnahme und Fehlersuche können dadurch signifikant erleichtert werden. Die Vorteile einer einfachen Inbetriebnahme können daher auch bei komplexen Schaltschrankinstallationen angewendet werden

Die Erfindung ermöglicht einen Feldbussystembaukasten, der intuitiv zusammenfügbar ist, gleichzeitig mit der mechanischen Fügung auch alle elektrischen Verbindungen herstellt und außerhalb und innerhalb eines Schaltschranks verwendbar ist. Der Feldbussystembaukasten stellt ein verdrahtungsfreies Geräteaufbausystem dar, das IP20 bis IP6x Anforderungen genügt. Daneben ermöglicht der Feldbussystembaukasten einen einfachen Anschluss als Knoten in einem Energieverteiler- Netzwerk beliebiger Struktur, beispielsweise Linie, Baum, Ring oder Netz.

Das Feldbusbaukastensystem kann beispielsweise in modularen Feldstationen nach IP6x-Anforderungen, Schaltschränken, Schaltkästen oder Maschinensockeln eingesetzt werden. Die Erfindung kann für ein Errichten von Nieder- und Kleinspannungsverteilungen oder einen Aufbau von modularen oder verteilten Feldstationen in einem Automatisierungsnetzwerk verwendet werden. Im Allgemeinen kann die Erfindung zum Schalten, Schützen, Steuern und Regeln von Verbrauchern verwendet werden.

Der Schutzbereich der vorliegenden Erfindung ist durch die Ansprüche gegeben und wird durch die in der Beschreibung erläuterten oder den Figuren gezeigten Merkmale nicht beschränkt.

### BEZUGSZEICHENLISTE

- 100: Trägermodul
- 100L: Linksseitiges Trägermodul
- 100R: Rechtsseitiges Trägermodul
- 101L: erster Steckverbinder
- 101R: zweiter Steckverbinder
- 103L: Niederspannungssteckverbinder
- 103R: Niederspannungssteckverbinder
- 105L: Kleinspannungssteckverbinder
- 105R: Kleinspannungssteckverbinder
- 107L: Datensteckverbinder
- 107R: Datensteckverbinder
- 109L: Erste Reihe
- 109R: Zweite Reihe
- 111L-1: Arretierungsöffnung
- 111L-2: Arretierungsöffnung
- 111R-1: Arretierungsöffnung
- 111R-2: Arretierungsöffnung
- 113: Schraube
- 115L: Elastomerkörper
- 115R: Elastomerkörper
- 117: Aussparung
- 119: Aussparung
- 121: Rasteinrichtung
- 123: Aussparung
- 125: Aussparung

- 200: Feldbusmodul
- 200L: Feldbusmodul
- 200R: Feldbusmodul
- 201L: Erster Steckverbinder
- 201R: Zweiter Steckverbinder
- 203: Arretierungsschaft
- 205: Arretierungshebel
- 207: Querriegel
- 209: Feder
- 211: Scheibe
- 213: Kante
- 215: Ringplatte
- 217: Hohlraum

- 300: Tragprofil

- 400: Feldbusbaukastensystem

## Patentansprüche

1. Trägermodul (100) für Feldbusmodule (200L, 200R), mit:
- einem ersten Steckverbinder (101L) zum elektrischen und mechanischen Verbinden eines linksseitigen Feldbusmoduls (200L) mit dem Trägermodul (100); und
- einem zweiten Steckverbinder (101R) zum elektrischen und mechanischen Verbinden eines rechtseitigen Feldbusmoduls (200R) mit dem Trägermodul (100),
**dadurch gekennzeichnet, dass** das Trägermodul auf ein Tragprofil aufrastbar und auf dem Tragprofil verschiebbar ist, wobei der erste Steckverbinder (101L) einen ersten Niederspannungssteckverbinder (103L), einen ersten Kleinspannungssteckverbinder (105L) und einen ersten Datensteckverbinder (107L) und der zweite Steckverbinder (101R) einen zweiten Niederspannungssteckverbinder (103R), einen zweiten Kleinspannungssteckverbinder (105R) und einen zweiten Datensteckverbinder (107R) umfasst, und
wobei der erste Niederspannungssteckverbinder (103L), der erste Kleinspannungssteckverbinder (105L) und der erste Datensteckverbinder (107L) in einer ersten Reihe (109L) an einer ersten Seite des Trägermoduls (100) und der zweite Niederspannungssteckverbinder (103R), der zweite Kleinspannungssteckverbinder (105R) und der zweite Datensteckverbinder (107R) in einer zweiten Reihe (109R) an einer zweiten Seite des Trägermoduls (100) angeordnet sind.

2. Trägermodul (100) nach Anspruch 1, wobei das Trägermodul (100) eine Arretierungsöffnung (111) zum Einsetzen eines Arretierungsschaftes (203) umfasst, um ein Feldbusmodul (200) auf dem Trägermodul (100) zu arretieren.

3. Trägermodul (100) nach Anspruch 2, wobei das Trägermodul (100) eine erste und eine zweite Arretierungsöffnung (111L-1, 111L-2) für ein linksseitiges Feldbusmoduls (200L) und eine erste und eine zweite Arretierungsöffnung (111R-1, 111R-2) für ein rechtsseitiges Feldbusmodul (200R) umfasst.

4. Trägermodul (100) nach Anspruch 3, wobei das Trägermodul eine im Querschnitt rechteckige Grundfläche aufweist und die erste Arretierungsöffnung (111L-1) für das linksseitige Feldbusmodul (200L) in einer ersten Ecke, die zweite Arretierungsöffnung (111L-2) für das linksseitige Feldbusmodul (200L) in einer zweiten Ecke, die erste Arretierungsöffnung (111R-1) für das rechtsseitige Feldbusmodul (200R) in einer dritten Ecke und die zweite Arretierungsöffnung (111R-2) für das rechtsseitige Feldbusmodul (200R) in einer vierten Ecke angeordnet sind.

5. Feldbusmodul (200) zum Aufstecken auf ein linksseitiges Trägermodul gemäß Anspruch 1 (100L) und ein rechtseitiges Trägermodul gemäß Anspruch 1 (100R), die auf einem Tragprofil (300) angeordnet sind, mit:
einem ersten Steckverbinder (201R) zum elektrischen und mechanischen Verbinden des Feldbusmoduls (200) mit dem rechtseitigen Trägermodul (100R); und
einem zweiten Steckverbinder (201L) zum elektrischen und mechanischen Verbinden des Feldbusmoduls (200) mit dem linksseitigen Trägermodul (200L),
wobei der erste Steckverbinder (201L) einen ersten Niederspannungssteckverbinder, einen ersten Kleinspannungssteckverbinder und einen ersten Datensteckverbinder und der zweite Steckverbinder einen zweiten Niederspannungssteckverbinder, einen zweiten Kleinspannungssteckverbinder und einen zweiten Datensteckverbinder umfasst, und
wobei der Niederspannungssteckverbinder, der erste Kleinspannungssteckverbinder und der erste Datensteckverbinder in einer ersten Reihe an einer ersten Seite des Feldbusmoduls (200) und der zweite Niederspannungssteckverbinder, der zweite Kleinspannungssteckverbinder und der zweite Datensteckverbinder in einer zweiten Reihe an einer zweiten Seite des Feldbusmoduls angeordnet sind.

6. Feldbusmodul (200) nach Anspruch 5, wobei das Feldbusmodul (200) einen Arretierungsschaft (203) zum Einsetzen in eine Arretierungsöffnung (111) in dem Trägermodul (100) umfasst, um das Feldbusmodul (200) auf dem Trägermodul (100) zu arretieren.

7. Feldbusmodul (200) nach Anspruch 6, wobei das Feldbusmodul einen ersten Arretierungsschaft und einen zweiten Arretierungsschaft für ein linksseitiges Trägermodul (100L) und einen ersten Arretierungsschaft und einen zweiten Arretierungsschaft für ein rechtsseitiges Trägermodul (100R) umfasst.

8. Feldbusmodul (200) nach Anspruch 7, wobei das Feldbusmodul (200) eine im Querschnitt rechteckige Grundfläche aufweist und der erste Arretierungsschaft für das linksseitige Trägermodul in einer ersten Ecke, der zweite Arretierungsschaft für das linksseitige Trägermodul (100L) in einer zweiten Ecke, der erste Arretierungsschaft für das rechtsseitige Trägermodul (100R) in einer dritten Ecke und der zweite Arretierungsschaft für das rechtsseitige Trägermodul in einer vierten Ecke angeordnet sind.

9. Feldbusmodul (200) nach einem der Ansprüche 6 bis 8, wobei der Arretierungsschaft (203) durch einen Arretierungshebel (205) zwischen einer Freigabeposition zum Freigeben des Feldbusmoduls (200) und einer Verriegelungsposition zum Verriegeln des Feldbusmoduls (200) drehbar ist.

10. Feldbusbaukastensystem (400) mit einem Trägermodul (100) nach einem der Ansprüche 1 bis 4 und einem Feldbusmodul (200) nach einem der Ansprüche 5 bis 9.

11. Feldbusbaukastensystem (400) mit einem Trägermodul (100) nach einem der Ansprüche 1 bis 4 und einem ersten und einem zweiten Feldbusmodul (200R, 200L) nach einem der Ansprüche 5 bis 9, wobei durch das Trägermodul (100) ein Abstand zwischen dem ersten Feldbusmodul (200R) und dem zweiten Feldbusmodul (200L) herstellbar ist, um eine Luftkonvektion zwischen dem ersten Feldbusmodul (200R) und dem zweiten Feldbusmodul (200L) zu ermöglichen.

## Claims

1. Carrier module (100) for fieldbus modules (200L, 200R), comprising:
- a first plug-in connector (101L) for electrically and mechanically connecting a left-hand-side fieldbus module (200L) to the carrier module (100), and
- a second plug-in connector (101R) for electrically and mechanically connecting a right-hand-side fieldbus module (200R) to the carrier module (100), **characterized in that** the carrier module can be latched onto a load-bearing profile and can be moved on the load-bearing profile,
wherein the first plug-in connector (101L) comprises a first low-voltage plug-in connector (103L), a first extra-low-voltage plug-in connector (105L) and a first data plug-in connector (107L) and the second plug-in connector (101R) comprises a second low-voltage plug-in connector (103R), a second extra-low-voltage plug-in connector (105R) and a second data plug-in connector (107R), and
wherein the first low-voltage plug-in connector (103L), the first extra-low-voltage plug-in connector (105L) and the first data plug-in connector (107L) are arranged in a first row (109L) on a first side of the carrier module (100) and the second low-voltage plug-in connector (103R), the second extra-low-voltage plug-in connector (105R) and the second data plug-in connector (107R) are arranged in a second row (109R) on a second side of the carrier module (100).

2. Carrier module (100) according to Claim 1, wherein the carrier module (100) comprises a locking opening (111) for inserting a locking shaft (203) in order to lock a fieldbus module (200) on the carrier module (100).

3. Carrier module (100) according to Claim 2, wherein the carrier module (100) comprises a first and a second locking opening (111L-1, 111L-2) for a left-hand-side fieldbus module (200L) and a first and a second locking opening (111R-1, 111R-2) for a right-hand-side fieldbus module (200R).

4. Carrier module (100) according to Claim 3, wherein the carrier module has a base area which is rectangular in cross section and the first locking opening (111L-1) for the left-hand-side fieldbus module (200L) is arranged in a first corner, the second locking opening (111L-2) for the left-hand-side fieldbus module (200L) is arranged in a second corner, the first locking opening (111R-1) for the right-hand-side fieldbus module (200R) is arranged in a third corner and the second locking opening (111R-2) for the right-hand-side fieldbus module (200R) is arranged in a fourth corner.

5. Fieldbus module (200) for mounting on a left-hand-side carrier module (100L) according to Claim 1 and a right-hand-side carrier module (100R) according to Claim 1, which carrier modules are arranged on a load-bearing profile (300), comprising:
a first plug-in connector (201R) for electrically and mechanically connecting the fieldbus module (200) to the right-hand-side carrier module (100R), and
a second plug-in connector (201L) for electrically and mechanically connecting the fieldbus module (200) to the left-hand-side carrier module (200L),
wherein the first plug-in connector (201L) comprises a first low-voltage plug-in connector, a first extra-low-voltage plug-in connector and a first data plug-in connector and the second plug-in connector comprises a second low-voltage plug-in connector, a second extra-low-voltage plug-in connector and a second data plug-in connector, and
wherein the low-voltage plug-in connector, the first extra-low-voltage plug-in connector and the first data plug-in connector are arranged in a first row on a first side of the fieldbus module (200) and the second low-voltage plug-in connector, the second extra-low-voltage plug-in connector and the second data plug-in connector are arranged in a second row on a second side of the fieldbus module.

6. Fieldbus module (200) according to Claim 5, wherein the fieldbus module (200) comprises a locking shaft (203) for insertion into a locking opening (111) in the carrier module (100) in order to lock the fieldbus module (200) on the carrier module (100).

7. Fieldbus module (200) according to Claim 6, wherein the fieldbus module comprises a first locking shaft and a second locking shaft for a left-hand-side carrier module (100L) and a first locking shaft and a second locking shaft for a right-hand-side carrier module (100R).

8. Fieldbus module (200) according to Claim 7, wherein the fieldbus module (200) has a base area which is rectangular in cross section and the first locking shaft for the left-hand-side carrier module is arranged in a first corner, the second locking shaft for the left-hand-side carrier module (100L) is arranged in a second corner, the first locking shaft for the right-hand-side carrier module (100R) is arranged in a third corner and the second locking shaft for the right-hand-side carrier module is arranged in a fourth corner.

9. Fieldbus module (200) according to one of Claims 6 to 8, wherein the locking shaft (203) can be rotated, by a locking lever (205), between a release position for releasing the fieldbus module (200) and a locking position for locking the fieldbus module (200).

10. Modular fieldbus system (400) comprising a carrier module (100) according to one of Claims 1 to 4 and a fieldbus module (200) according to one of Claims 5 to 9.

11. Modular fieldbus system (400) comprising a carrier module (100) according to one of Claims 1 to 4 and a first and a second fieldbus module (200R, 200L) according to one of Claims 5 to 9, wherein a distance can be established between the first fieldbus module (200R) and the second fieldbus module (200L) by the carrier module (100) in order to allow air convection between the first fieldbus module (200R) and the second fieldbus module (200L).

## Revendications

1. Module support (100) destiné à des modules bus de terrain (200L, 200R), comprenant :
- un premier connecteur enfichable (101L), servant à raccorder électriquement et mécaniquement un module bus de terrain côté gauche (200L) au module support (100) ; et
- un deuxième connecteur enfichable (101R), servant à raccorder électriquement et mécaniquement un module bus de terrain côté droit (200R) au module support (100), **caractérisé en ce que** le module support peut être encliqueté sur un profilé de support et coulisser sur ce dernier,
dans lequel le premier connecteur enfichable (101L) comprend un premier connecteur basse tension (103L), un premier connecteur faible tension (105L) et un premier connecteur de données (107L) et le deuxième connecteur enfichable (101R) comprend un deuxième connecteur basse tension (103R), un deuxième connecteur faible tension (105R) et un deuxième connecteur de données (107R), et dans lequel le premier connecteur basse tension (103L), le premier connecteur faible tension (105L) et le premier connecteur de données (107L) sont disposés dans une première rangée (109L) sur un premier côté du module support (100) et le deuxième connecteur basse tension (103R), le deuxième connecteur faible tension (105R) et le deuxième connecteur de données (107R) sont disposés dans une deuxième rangée (109R) sur un deuxième côté du module support (100).

2. Module support (100) selon la revendication 1, dans lequel le module support (100) comprend une ouverture de blocage (111) servant à insérer un arbre de blocage (203) afin de bloquer un module bus de terrain (200) sur le module support (100).

3. Module support (100) selon la revendication 2, dans lequel le module support (100) comprend des première et deuxième ouvertures de blocage (111L-1, 111L-2) destinées à un module bus de terrain côté gauche (200L) et des première et deuxième ouvertures de blocage (111R-1, 111R-2) destinées à un module bus de terrain côté droit (200R).

4. Module support (100) selon la revendication 3, dans lequel le module support présente une surface de base de section transversale rectangulaire et la première ouverture de blocage (111L-1) destinée au module bus de terrain côté gauche (200L) est disposée dans un premier angle, la deuxième ouverture de blocage (111L-2) destinée au module bus de terrain côté gauche (200L) est disposée dans un deuxième angle, la première ouverture de blocage (111R-1) destinée au module bus de terrain côté droit (200R) est disposée dans un troisième angle et la deuxième ouverture de blocage (111R-2) destinée au modules bus de terrain côté droit (200R) est disposée dans un quatrième angle.

5. Module bus de terrain (200) à enficher sur un module support côté gauche selon la revendication 1 (100L) et un module support côté droit selon la revendication 1 (100R), qui sont disposés sur un profilé de support (300), comprenant :
un premier connecteur enfichable (201R), servant à raccorder électriquement et mécaniquement le module bus de terrain (200) au module support côté droit (100R) ; et
un deuxième connecteur enfichable (201L), servant à raccorder électriquement et mécaniquement le module bus de terrain (200) au module support côté gauche (200L),
dans lequel le premier connecteur enfichable (201L) comprend un premier connecteur basse tension, un premier connecteur faible tension et un premier connecteur de données et le deuxième connecteur enfichable comprend un deuxième connecteur basse tension, un deuxième connecteur faible tension et un deuxième connecteur de données, et
dans lequel le connecteur basse tension, le premier connecteur faible tension et le premier connecteur de données sont disposés dans une première rangée sur un premier côté du module bus de terrain (200) et le deuxième connecteur basse tension, le deuxième connecteur faible tension et le deuxième connecteur de données sont disposés dans une deuxième rangée sur un deuxième côté du module bus de terrain.

6. Module bus de terrain (200) selon la revendication 5, dans lequel le module bus de terrain (200) comprend un arbre de blocage (203) destiné à être inséré dans une ouverture de blocage (111) dans le module support (100) pour bloquer le module bus de terrain (200) sur le module support (100).

7. Module bus de terrain (200) selon la revendication 6, dans lequel le module bus de terrain comprend un premier arbre de blocage et un deuxième arbre de blocage destinés à un module support côté gauche (100L) et un premier arbre de blocage et un deuxième arbre de blocage destinés à un module support côté droit (100R).

8. Module bus de terrain (200) selon la revendication 7, dans lequel le module bus de terrain (200) présente une surface de base de section transversale rectangulaire et le premier arbre de blocage destiné au module support côté gauche est disposé dans un premier angle, le deuxième arbre de blocage destiné au module support côté gauche (100L) est disposé dans un deuxième angle, le premier arbre de blocage destiné au module support côté droit (100R) est disposé dans un troisième angle et le deuxième arbre de blocage destiné au module support côté droit est disposé dans un quatrième angle.

9. Module bus de terrain (200) selon l'une des revendications 6 à 8, dans lequel l'arbre de blocage (203) peut être mis en rotation par un levier de blocage (205) entre une position de libération permettant de libérer le module bus de terrain (200) et une position de verrouillage permettant de verrouiller le module bus de terrain (200).

10. Système de module de bus de terrain (400) comprenant un module support (100) selon l'une des revendications 1 à 4 et un module bus de terrain (200) selon l'une des revendications 5 à 9.

11. Système de bus de terrain modulaire (400) comprenant un module support (100) selon l'une des revendications 1 à 4 et des premier et deuxième modules bus de terrain (200R, 200L) selon l'une des revendications 5 à 9, dans lequel une distance entre le premier module bus de terrain (200R) et le deuxième module bus de terrain (200L) peut être établie par le module support (100) afin de permettre une convection d'air entre le premier module bus de terrain (200R) et le deuxième module bus de terrain (200L).
